# EUROPÄISCHE PATENTSCHRIFT

(11) **EP 1 771 883 B1**
(45) Veröffentlichungstag und Bekanntmachung des Hinweises auf die Patenterteilung: **04.11.2015**
(21) Anmeldenummer: 05771334.9
(22) Anmeldetag: 28.07.2005
(51) Int. Cl.: H01L 27/146, H01L 31/0203, H01L 31/0232

(54) **IMAGE-MODUL**
IMAGE MODULE
MODULE D'IMAGE

(30) Priorität: 28.07.2004 DE 202004011854 U
(43) Veröffentlichungstag der Anmeldung: 11.04.2007
(73) Patentinhaber: First Sensor Microelectronic Packaging GmbH, 01109 Dresden (DE); JENOPTIK Polymer Systems GmbH, 07819 Triptis (DE)
(72) Erfinder: LÖFFLER, Mario, 01159 Dresden (DE); SCHNEIDER, Werner, 01277 Dresden (DE); WOLDT, Gregor, 01159 Dresden (DE); KARL, Stephan, 01471 Grossdittmannsdorf (DE); FISCHER, Andreas, 07980 Berga (DE)
(74) Vertreter: Hudler, Frank
(86) Internationale Anmeldenummer: PCT/DE2005/001339
(87) Internationale Veröffentlichungsnummer: WO 2006/012866

(56) Entgegenhaltungen:
- EP-A- 0 585 186
- EP-A- 0 753 893
- EP-A- 0 769 817
- EP-A- 1 263 055
- EP-A- 1 351 496
- US-A- 5 424 531

## Beschreibung

Die Erfindung betrifft ein Image-Modul, bestehend aus den Hauptelementen Modulboard mit darauf durch eine COB-Technologie oder mittels Flip-Chip-Technologie auf dessen Rückseite montiertem Image-Sensor, sowie ggf. weiteren Funktions- und Kontaktelementen auf der Vorder- und/oder Rückseite des Modulboards, sowie einem Abdeckelement zur Abdeckung des Modulboardes mit einem Linsensystem, das über dem aktiven Bereich des Image-Sensors des Image-Sensorchip angeordnet sein kann und wobei zur Positionierung des Linsensystems Abstandselemente vorgesehen sind.

Derartige Image-Module werden in unterschiedlichen Baugrößen für die verschiedensten Bildaufnahmezwecke, z.B. in Videooder beliebigen Bildaufnahmeeinrichtungen, verwendet. Im Wesentlichen enthalten derartige Image Module das Modulboard, auf dem ein Image-Sensor (Bildaufnahmeelement) beliebiger Bauart durch Chipbonden, z.B. Kleben, befestigt ist. Der Image-Sensor besitzt einen aktiven Bereich, um die auf diesen Bereich über das Linsensystem abgebildeten Bilder in elektrische Signale umzuwandeln. Zur Übertragung und Bearbeitung dieser elektrischen Signale befinden sich auf dem Modulboard weitere Funktionselemente, wie Schaltkreise und SMD-Bauelemente, die z.B. über Drahtbrücken oder andere geeignete Verbindungselemente miteinander und mit dem Modulboard elektrisch verbunden sind. Schließlich sind am Modulboard noch Kontaktelemente befestigt, mit denen das Image-Modul z.B. auf Leiterplatten montiert werden kann.

Für die Abbildung eines Bildes auf dem aktiven Bereich des Image-Sensors befindet sich im Abdeckelement das bereits erwähnte Linsensystem, bestehend aus mindestens einer Linse. In der Regel sind jedoch mehrere in einem fest zueinander vorgegebenen Abstand montierte, ein Objektiv bildenden Linsen vorgesehen, deren optischen Achsen genau senkrecht auf dem aktiven Bereich des Image Sensors stehen müssen. Außerdem müssen sich die Linsen, bzw. das aus mehreren Linsen bestehende Objektiv, bzw. dessen optische Ebene in einem genau vorgegebenen Abstand über dem aktiven Bereich des Image Sensors befinden. Dabei muss weiterhin sichergestellt sein, dass sich der Abstand der Linsen zum Modulboard während des Gebrauchs des Image-Moduls nicht verändern kann.

Bei der Herstellung solcher Image-Module ist die Justierung der Linsen bzw. des Objektivs über dem Image-Sensor und insbesondere die korrekte Einstellung des Abstandes zum Image Sensor, also des Fokusses besonders heikel und zeitaufwändig. Beispielsweise können die Linsen in einer Aufnahme im Abdeckelement angeordnet sein, die gegenüber dem Image-Sensor durch Drehen oder Verschieben einstellbar ist.

Derartige Ausführungen sind jedoch für eine kostengünstige Fokussierung nicht geeignet, zumal eine präzise und gleichbleibend genaue Einstellung des Fokusses schwer realisierbar ist.

Aus der EP 0 753 893 A2 ist eine Image-Sensor-Anordnung bestehend aus einem Image-Sensor auf einer Leiterplatte, einem darüber positionierten Keramikrahmen, sowie einer Montageplatte zur Aufnahme einer Linse bekannt geworden.. Aus der Montageplatte hervorstehenden Justierstifte erstrecken sich durch Löcher in einer Keramikplatte, die auf dem Modul-Board aufliegt. Die Löcher setzen sich im Modul-Board mit kleinerem Durchmesser fort, so dass sich aus dem vorderen Ende von zwei der Justierstifte hervorstehende Pins mit entsprechendem Durchmesser in die kleineren Löcher erstrecken. Im montierten Zustand sitzen die Justierstifte somit auf dem Modul-Board auf, wodurch neben der x-y-Positionierung auch der Abstand zwischen der Montageplatte und dem Modul-Board festgelegt ist.

Eine hinreichend genaue Definition des Abstandes des Image-Sensors zur Linse ist allerdings nicht möglich.

Der Erfindung liegt daher die Aufgabe zugrunde, einen Image-Modul zu schaffen, bei dem die beschriebenen Nachteile nicht auftreten und bei dem insbesondere eine einfache, präzise und schnelle Montage der Funktionsbaugruppen mit präziser Zuordnung des Abstandes zwischen der Oberfläche des Image-Sensors und dem Linsensystem ermöglicht wird.

Die der Erfindung zugrunde liegende Aufgabe wird durch die kennzeichnenden Merkmale des Anspruchs 1 gelöst. Weitere Ausgestaltungen der Erfindung gehen aus den zugehörigen Unteransprüchen hervor.

Die Erfindung wird nachfolgend an einem Ausführungsbeispiel näher erläutert. In den zugehörigen Zeichnungsfiguren zeigen:
- Fig. 1:: eine Schnittdarstellung eines Image-Modules mit in COB-Technologie auf einem Modulboard montiertem Image-Sensor, mit auf dem Image-Sensor angeordneten Abstandselementen, sowie einem zugehörigen Abdeckelement mit Linsensystem;
- Fig. 2:: eine Schnittdarstellung eines Image-Modules mit in COB-Technologie montiertem Image-Sensor mit Abstandselementen auf dem Modulboard und/oder anderen Bauelementen, wie ASIC-Bauelementen, sowie einem zugehörigen Abdeckelement mit Linsensystem;
- Fig. 3:: eine Seitenansicht eines fertig montierten Image-Modules nach Fig. 1 oder Fig. 2;
- Fig. 4:: eine Schnittdarstellung eines Image-Moduls mit einem in Flip-Chip-Technologie montierten Image-Sensor mit auf dem Modulboard und/oder anderen Bauelementen, wie ASIC-Bauelementen, angeordneten Abstandselementen; und

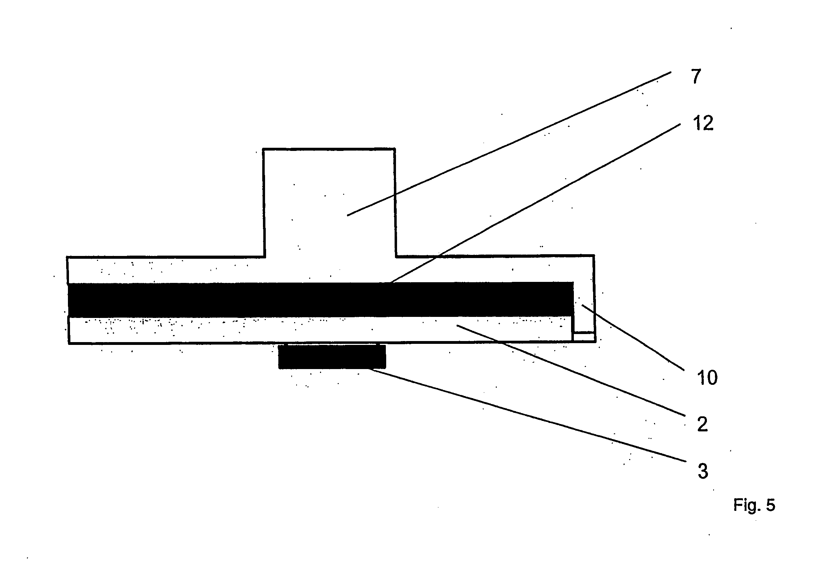

- Fig. 5:: eine Seitenansicht eines fertig montierten Image-Modules nach Fig. 4.

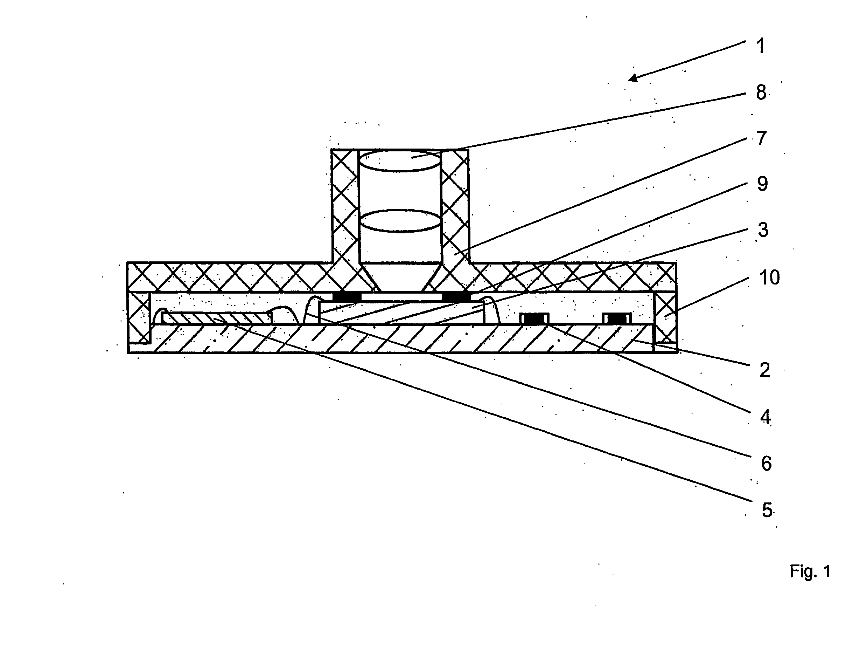

Aus Fig. 1 ist ein Image-Modul 1, bestehend aus den Hauptelementen Modulboard 2 (Grundplatte/Substrat) mit darauf oder mittels COB-Technologie montiertem Image-Sensor 3 (Bildaufnahmeelement). Weitere auf dem Modulboard 2 montierte Funktions- und Kontaktelementen sind SMD-Bauelemente 4 und ASIC-Bauelemente 5, deren elektrische Kontaktierung mit dem Modulboard über Drahtbrücken 6 erfolgt.

Mit dem Modulboard 2 fest verbunden ist ein Abdeckelement 7 mit einem Linsesystem 8, welches sich in genau definiertem Abstand über dem aktiven Bereich des Image-Sensors 3 befindet.

Um eine einfache Montage des Abdeckelementes 7 auf dem Modulboard 2 zu gewährleisten und gleichzeitig sicher zu stellen, dass der vorgegebene Abstand zwischen Image-Sensor 3 und Linsensystem 8 reproduzierbar eingehalten wird, sind zwischen dem Modulboard 2 und dem Abdeckelement 7 Abstandselemente 9 angeordnet, die den Luftspalt 11 zwischen dem Image-Sensor 3 und dem Linsensystem 8 definieren.

Für die x-y-Positionierung des Abdeckelementes 7 sind weiterhin Justierelemente 10 in Form von Stiften vorgesehen, die mit dem Abdeckelement 7 fest verbunden sind und in Löcher im Modulboard 2 eingreifen.

Gemäß Fig. 1 sind die Abstandselemente 9 auf dem Image-Sensor 3 positioniert, wodurch die höchste Genauigkeit bei der Festlegung des Abstandes zwischen Linsensystem 8 und Image-Sensor 3 erreicht.

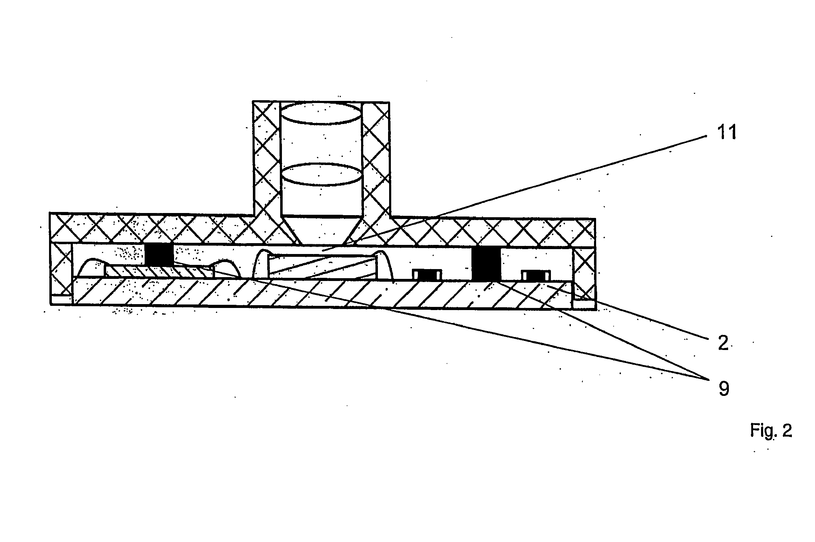

Fig. 2 zeigt eine Variante, bei welcher der Abstand zwischen dem Image-Sensor 3 und dem Linsensystem 8 durch Abstandselemente 9 auf dem Modulboard 2 definiert ist. Die Länge der Abstandselemente 9 bestimmt sich dabei durch den vorgegebenen Abstand zwischen der Oberfläche des Image-Sensors 3 und dem Linsensystem 8 zuzüglich der Dicke des Image-Sensors 3 und zuzüglich der Dicke der Klebeschicht zwischen Image-Sensor 3 und dem Modulboard 2. Diese Variante ist dann notwendig, wenn auf dem Image-Sensor 3 nicht genügend Fläche für die Abstandselemente 9 verfügbar ist.

Die Abstandselemente 9 können auch zusätzlich auf anderen montierten Komponenten auf dem Modulboard 2 angeordnet werden.

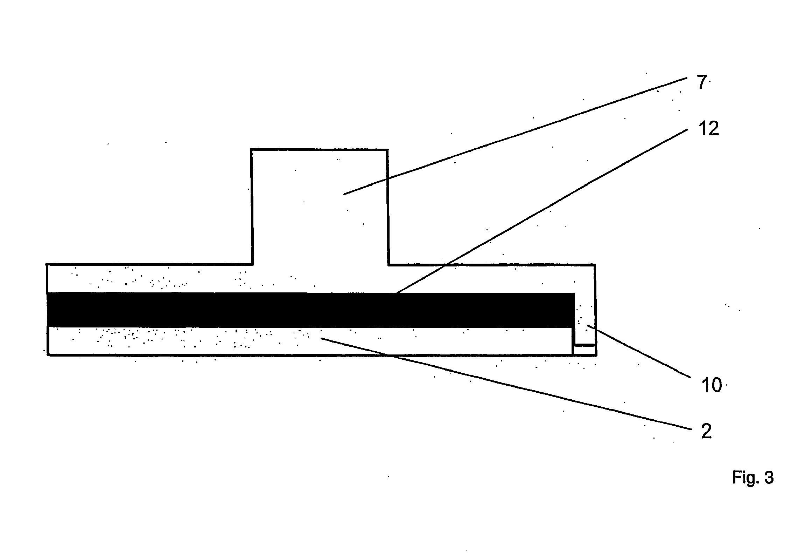

Das Abdeckelement 7 schließt gleichzeitig das Modulboard 2 nach oben ab (Fig. 3), wobei durch ein Epoxydharz 12 eine feste Verbindung zwischen Modulboard 2 und Abdeckelement 7 hergestellt wird.

Wird das Abdeckelement 7 als Kappe ausgeführt, die das Modulboard 2 seitlich umschließt, wird gleichzeitig eine seitliche mechanische und optische Abgrenzung des optischen Bereiches des Image-Sensors 3 realisiert.

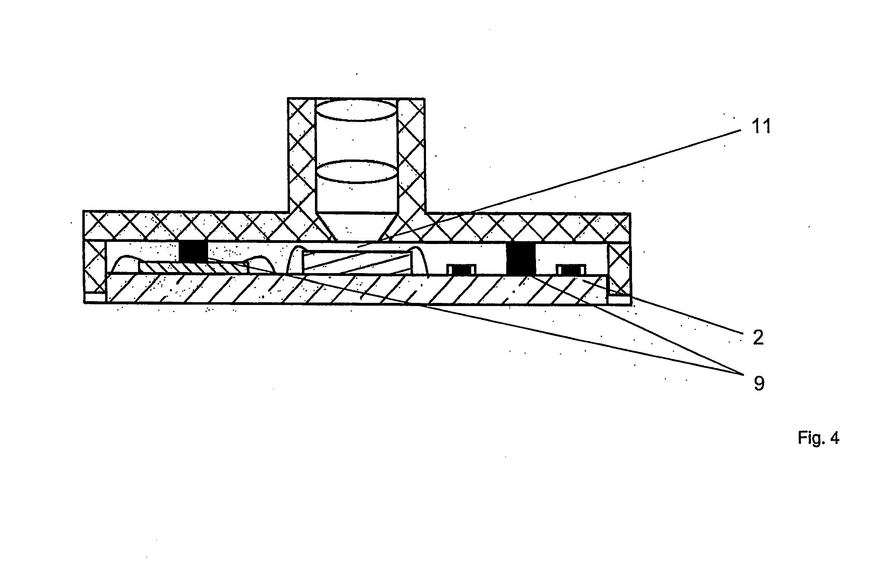

Fig. 4 zeigt eine Schnittdarstellung eines Image-Moduls 1 mit einem in Flip-Chip-Technologie montierten Image-Sensor 3 auf der Unterseite des Modulboardes 2 sowie weiteren SMD-und ASIC-Bauelementen 4, 5 auf dem Modulboard 2 und Abstandselementen 9 auf dem Modulboard 2.

In einer Variante sind die Ränder des Abdeckelementes 7 plattenförmig ausgeführt, wobei die Befestigung auf dem Modulboard 2 durch einen zusätzlich aufgebrachten Klebstoff 12, z.B. Epoxydharz, oder eine Klebefolie, realisiert ist. Diese Variante ist von besonderem Vorteil, wenn die gleichzeitige komplette Montage einer Vielzahl von Image-Modulen 1 im Nutzverbund erfolgen soll.

Zusätzlicher Klebstoff, welcher beim Aufsetzen des Abdeckelementes 7 auf den Modulboard 2 seitlich ausgetreten ist, kann durch geeignete Verfahren, wie Schneiden oder Sägen, bevorzugt während des Vereinzelns der Image-Module 1 aus dem Nutzverbund einfach entfernt werden.

### Bezugszeichenliste

- 1: Image-Modul
- 2: Modulboard
- 3: Image-Sensor
- 4: SMD-Bauelement
- 5: ASIC-Bauelement
- 6: Drahtbrücke
- 7: Abdeckelement
- 8: Linsensystem
- 9: Abstandselement
- 10: Justierelement
- 11: Luftspalt
- 12: Klebstoff

## Patentansprüche

1. Image-Modul, bestehend aus den Hauptelementen Modul-Board mit darauf durch eine COB-Technologie oder mittels Flip-Chip-Technologie auf dessen Rückseite montiertem Image-Sensor, sowie ggf. weiteren Funktions- und Kontaktelementen auf der Vorder- und/oder Rückseite des ModulBoards, sowie einem Abdeckelement zur Abdeckung des Modul-Boardes mit einem Linsensystem, das über dem aktiven Bereich des Image-Sensors des Image-Sensorchip angeordnet ist, wobei für die x-y-Positionierung des Abdeckelementes Justierelemente vorgesehen sind, die in Löcher im Modul-Board eingreifen und wobei zur Positionierung des Linsensystems Abstandselemente vorgesehen sind, wobei zwischen dem Modul-Board (2) und dem Abdeckelement (7) drei Abstandselemente (9) im Abstand zueinander angeordnet sind, welche den Abstand zwischen dem Image-Sensor (3) auf dem Modul-Board (2) und dem Linsensystem (8) im Abdeckelement (7) durch Definition eines vorgegebenen Luftspaltes (11) zwischen Image-Sensor (3) und dem Linsensystem (8) festlegen, **dadurch gekennzeichnet, dass** die Abstandselemente (9) Bestandteile des Abdeckelementes (7) sind, wobei sich die Abstandselemente (9) auf dem Image-Sensor (3) oder anderen auf dem Modul-Board (2) montierten Komponenten abstützen und dass zusätzlich Justierelemente (10) in Form von Stiften vorgesehen sind, die mit dem Abdeckelement (7) fest verbunden sind und in Löcher im Modul-Board (2) eingreifen.

2. Image-Modul nach Anspruch 1, **dadurch gekennzeichnet, dass** die Abstandselemente (9) eine Länge aufweisen, die durch den vorgegebenen Abstand zwischen der Oberfläche des Image-Sensors (3) und dem Linsensystem (8) zuzüglich der Dicke des Image-Sensors (3) und zuzüglich der Dicke der Kleberschicht zwischen Image-Sensor (3) und Modul-Board (2) bestimmt ist.

3. Image-Modul nach einem der Ansprüche 1 und 2, **dadurch gekennzeichnet, dass** die Lage des im Abdeckelement (7) befindlichen Linsensystems (8) in x-, y-Richtung über die Justierelemente (10) und in z-Richtung zur Image-Sensorfläche über die Länge der Abstandselemente (9) definiert ist.

4. Image-Modul nach einem der Ansprüche 1 bis 3, **dadurch gekennzeichnet, dass** das Abdeckelement (7) gleichzeitig das Modul-Board (2) nach oben abschließt.

5. Image-Modul nach Anspruch 1, **dadurch gekennzeichnet, dass** das Abdeckelement (7) als dichtende Kappe ausgeführt ist und somit eine seitliche mechanische und optische Abgrenzung des optischen Bereiches des Image-Modules (1) realisiert.

6. Image-Modul nach Anspruch 1, **dadurch gekennzeichnet, dass** das dichtende Abdeckelement (7) plattenförmig ausgeführt ist und dass die seitliche Begrenzung durch einen zusätzlich aufgebrachten Klebstoff, z.B. Epoxydharz oder einem anderen geeigneten Klebstoff, realisiert ist.

## Claims

1. Image module comprising the main elements, a module board, having on the rear side thereof an image sensor mounted by using COB technology or by means of flip chip technology, and comprising, if appropriate, further function elements and contact elements on the front and/or rear side of the module board, and comprising a cover element for covering the module board with a lens system which is arranged over the active region of the image sensor of the image sensor chip, there being provided for the x-y positioning of the cover element adjusting elements which engage in holes in the module board, and spacing elements being provided for positioning the lens system, there being arranged at a spacing, between the module board (2) and the cover element (7), three spacing elements (9) which fix the spacing between the image sensor (3) on the module board (2) and the lens system (8) in the cover element (7) by defining a prescribed air gap (11) between the image sensor (3) and the lens system (8), **characterized in that** the spacing elements (9) are components of the cover element (7), the spacing elements (9) being supported on the image sensor (3) or other components mounted on the module board (2) and **in that** in addition adjusting elements (10) are provided in the form of pins which are fixedly connected to the cover element (7) and engage in holes in the module board (2).

2. Image module according to Claim 1, **characterized in that** the spacing elements (9) have a length which is determined by the prescribed spacing between the surface of the image sensor (3) and the lens system (8) plus the thickness of the image sensor (3) and plus the thickness of the adhesive layer between the image sensor (3) and module board (2).

3. Image module according to either of Claims 1 and 2, **characterized in that** the position of the lens system (8) situated in the cover element (7) is defined in the x-, y-direction via the adjusting elements (10) and in the z-direction in relation to the image sensor surface via the length of the spacing elements (9).

4. Image module according to one of Claims 1 to 3, **characterized in that** the cover element (7) simultaneously closes the module board (2) at the top.

5. Image module according to Claim 1, **characterized in that** the cover element (7) is designed as a sealing cap and thereby implements lateral mechanical and optical delimitation of the optical region of the image module (1).

6. Image module according to Claim 1, **characterized in that** the sealing cover element (7) is of plate form and **in that** the lateral delimitation is implemented by an additionally applied adhesive, for example epoxy resin or another suitable adhesive.

## Revendications

1. Module d'image, composé des éléments principaux de la carte de module avec un capteur d'image monté dessus sur son côté arrière par le biais d'une technologie COB ou d'une technologie de type puce retournée, ainsi que le cas échéant avec des éléments fonctionnels et de contact supplémentaires sur le côté avant et/ou arrière de la carte de module, ainsi qu'avec un élément de cache servant à recouvrir la carte de module avec un système de lentilles disposé sur la zone active du capteur d'image de la puce de capteur d'image, sachant que des éléments d'ajustement sont prévus pour le positionnement x-y de l'élément de cache, lesdits éléments d'ajustement s'imbriquant dans les trous prévus dans la carte de module et sachant que des éléments d'écartement sont prévus pour le positionnement du système de lentilles, trois éléments d'écartement (9) étant disposés à une certaine distance les uns des autres entre la carte de module (2) et l'élément de cache (7), lesdits éléments déterminant l'écartement entre le capteur d'image (3) prévu sur la carte de module (2) et le système de lentilles (8) prévu dans l'élément de cache (7) par définition d'un interstice d'air (11) prédéfini entre le capteur d'image (3) et le système de lentilles (8), **caractérisé en ce que** les éléments d'écartement (9) sont des composants de l'élément de cache (7), les éléments d'écartement (9) s'appuyant sur le capteur d'image (3) ou sinon sur les composants montés sur la carte de module (2) et qu'en outre, des éléments d'ajustement (10) sont prévus sous la forme de tiges reliées de façon permanente à l'élément de cache (7) et s'imbriquant dans les trous prévus dans la carte de module (2).

2. Module d'image selon la revendication 1, **caractérisé en ce que** les éléments d'écartement (9) présentent une longueur déterminée par le pré-écartement défini entre la surface du capteur d'image (3) et le système de lentilles (8) par rapport à l'épaisseur du capteur d'image (3) et par rapport à l'épaisseur de la couche de colle entre le capteur d'image (3) et la carte de module (2).

3. Module d'image selon l'une quelconque des revendications 1 et 2, **caractérisé en ce que** la position du système de lentilles (8) se trouvant dans l'élément de cache (7) est définie dans la direction x, y via les éléments d'ajustement (10) et dans la direction z par rapport à la surface de capteur d'image, via la longueur des éléments d'écartement (9).

4. Module d'image selon l'une quelconque des revendications 1 à 3, **caractérisé en ce que** l'élément de cache (7) ferme simultanément la carte de module (2) vers le haut.

5. Module d'image selon la revendication 1, **caractérisé en ce que** l'élément de cache (7) prend la forme d'un bouchon étanche et réalise ainsi une délimitation mécanique et optique latérale de la zone optique du module d'image (1).

6. Module d'image selon la revendication 1, **caractérisé en ce que** l'élément de cache (7) étanche est réalisé en forme de plaque, que la délimitation latérale est réalisée par une colle appliquée en sus dessus, par exemple une résine époxy ou une autre colle adaptée.
